# EUROPEAN PATENT SPECIFICATION

(11) **EP 4 255 160 B1**
(45) Date of publication and mention of the grant of the patent: **27.08.2025**
(21) Application number: 23160680.7
(22) Date of filing: 08.03.2023
(51) Int. Cl.: H10N 30/50, H10N 30/30, H10N 30/87, H10N 30/01, H10N 30/07, H10N 30/072

(54) **PIEZOELECTRIC-BODY FILM JOINT SUBSTRATE AND MANUFACTURING METHOD THEREOF**
FILMVERBINDUNGSSUBSTRAT MIT PIEZOELEKTRISCHEM KÖRPER UND HERSTELLUNGSVERFAHREN DAFÜR
SUBSTRAT DE JOINT DE FILM DE CORPS PIÉZOÉLECTRIQUE ET SON PROCÉDÉ DE FABRICATION

(30) Priority: 30.03.2022 JP 2022055593
(43) Date of publication of application: 04.10.2023
(73) Proprietor: Oki Electric Industry Co., Ltd., Minato-ku Tokyo 105-8460 (JP)
(72) Inventor: FURUTA, Hironori, Tokyo 105-8460 (JP); KOSAKA, Toru, Tokyo 105-8460 (JP); SUZUKI, Takahito, Tokyo 105-8460 (JP); TANIGAWA, Kenichi, Tokyo 105-8460 (JP); ISHIKAWA, Takuma, Tokyo 105-8460 (JP); KITAJIMA, Yutaka, Tokyo 105-8460 (JP)
(74) Representative: Betten & Resch

(56) References cited:
- CN-A- 114 070 254
- JP-A- 2018 170 343
- US-A1- 2013 162 106
- US-A1- 2018 069 168
- US-A1- 2018 123 017

## Description

### BACKGROUND OF THE INVENTION

### 1. Field of the Invention

The present disclosure relates to a piezoelectric-body film joint substrate and a manufacturing method thereof.

### 2. Description of the Related Art

Conventionally, there has been proposed a device formed by stacking a plurality of piezoelectric films of different types. See Japanese Patent Application Publication No. 2018-190890 (Patent Reference 1), for example.

However, a high-performance device including a plurality of piezoelectric films cannot be obtained when a plurality of piezoelectric films of different types are stacked on the same substrate in a conventional device.

US 2013/162106 A1 relates to a vibration power generation element for converting vibration energy into electric energy, and a vibration power generation device including the vibration power generation element.

US 2018/069168 A1 relates to a piezoelectric device, a piezoelectric transformer, and a method of manufacturing the piezoelectric device.

US 2018/123017 A1 relates to a laminate structure for a piezoelectric element in which a piezoelectric portion is provided on each of opposite surfaces of a vibration plate, a piezoelectric element, and a method of manufacturing a piezoelectric element

JP 2018 170343 A relates to a piezoelectric element used for an ultrasonic transmission / reception device, a piezoelectric transformer, and the like, and a manufacturing method thereof.

CN 114 070 254 A relates to a semiconductor structure and a method for manufacturing the same, and an electronic device having the resonator assembly.

<INSERT DESCRIPTION PAGE 1A HERE>

### SUMMARY OF THE INVENTION

An object of the present disclosure is to provide a high-performance piezoelectric-body film joint substrate in which piezoelectric films of two or more types are provided in superimposition with each other on the same substrate and a manufacturing method thereof.

The present invention is defined in the independent claims 1 and 8. Embodiments are defined in the dependent claims.

A method of manufacturing a piezoelectric-body film joint substrate in the present disclosure includes peeling off a first piezoelectric-body film formed on a first substrate and including a first piezoelectric film and a first electrode film provided on the first piezoelectric film and a second piezoelectric-body film formed on a second substrate and including a second piezoelectric film and a second electrode film provided on the second piezoelectric film respectively from the first substrate and the second substrate, sticking the first piezoelectric-body film on an electrode formed on a third substrate different from both of the first substrate and the second substrate, and sticking the second piezoelectric-body film on the first piezoelectric-body film.

According to the present disclosure, it is possible to provide a high-performance piezoelectric-body film joint substrate in which piezoelectric films of two or more types are provided in superimposition with each other on the same substrate and a manufacturing method thereof.

### BRIEF DESCRIPTION OF THE DRAWINGS

The present disclosure will become more fully understood from the detailed description given hereinbelow and the accompanying drawings which are given by way of illustration only, and wherein:
Fig. 1 is a side view schematically showing the structure of a piezoelectric-body film joint substrate not forming part of the invention.
Fig. 2 is a top view schematically showing the structure of the piezoelectric-body film joint substrate in Fig. 1;
Fig. 3 is a cross-sectional view of the piezoelectric-body film joint substrate in Fig. 2 taken along the line S3-S3;
Fig. 4 is a flowchart showing a method of manufacturing the piezoelectric-body film joint substrate;
Figs. 5A and 5B are a top view and a cross-sectional view schematically showing the structure of a PZT epitaxial growth film in step ST101 in Fig. 4, and Figs. 5C and 5D are a top view and a cross-sectional view schematically showing the structure of the PZT epitaxial growth film in step ST102 in Fig. 4;
Figs. 6A and 6B are a top view and a cross-sectional view schematically showing the structure of an AlN epitaxial growth film in step ST104 in Fig. 4, and Figs. 6C and 6D are a top view and a cross-sectional view schematically showing the structure of the AlN epitaxial growth film in step ST105 in Fig. 4;
Figs. 7A and 7B are cross-sectional views schematically showing a holding process of a plurality of PZT piezoelectric-body films in step ST103 in Fig. 4;
Figs. 8A and 8B are cross-sectional views schematically showing a holding process of a plurality of AlN piezoelectric-body films in step ST106 in Fig. 4;
Fig. 9A is a cross-sectional view schematically showing a sticking process of the AlN piezoelectric-body film in step ST107 in Fig. 4, and Fig. 9B is a top view showing a state in which the AlN piezoelectric-body film has been stuck;
Fig. 10A is a cross-sectional view schematically showing a sticking process of the PZT piezoelectric-body film in step ST108 in Fig. 4, and Fig. 10B is a top view showing a state in which the PZT piezoelectric-body film has been stuck;
Fig. 11A is a cross-sectional view showing a manufacturing process of the next piezoelectric-body film joint substrate, and Fig. 11B is a top view showing a state in which the PZT piezoelectric--body film has been stuck;
Figs. 12A and 12B are a side view and a top view schematically showing the structure of a piezoelectric-body film joint substrate not forming part of the invention;
Figs. 13A and 13B are a side view and a top view schematically showing the structure of a piezoelectric-body film joint substrate according to the invention.
Fig. 14 is a cross-sectional view schematically showing the structure of an epitaxial growth film including a PZT piezoelectric-body film;
Fig. 15 is a cross-sectional view schematically showing the structure of an epitaxial growth film including an AlN piezoelectric-body film;
Fig. 16 is a flowchart showing a method of manufacturing the piezoelectric-body film joint substrate in Figs. 13A and 13B;
Figs. 17A and 17B are a top view and a cross-sectional view schematically showing the structure of a PZT epitaxial growth film in step ST201 in Fig. 16, and Figs. 17C and 17D are a top view and a cross-sectional view schematically showing the structure of the PZT epitaxial growth film in step ST202 in Fig. 16;
Figs. 18A and 18B are a top view and a cross-sectional view schematically showing the structure of an AlN epitaxial growth film in step ST204 in Fig. 16, and Figs. 18C and 18D are a top view and a cross-sectional view schematically showing the structure of the AlN epitaxial growth film in step ST205 in Fig. 16;
Figs. 19A and 19B are cross-sectional views schematically showing a holding process of a plurality of PZT piezoelectric-body films in step ST203 in Fig. 16;
Figs. 20A and 20B are cross-sectional views schematically showing a holding process of a plurality of AlN piezoelectric-body films in step ST206 in Fig. 16;
Fig. 21A is a cross-sectional view schematically showing a sticking process of the AlN piezoelectric-body film in step ST207 in Fig. 16, and Fig. 21B is a top view showing a state in which the AlN piezoelectric-body film has been stuck;
Fig. 22A is a cross-sectional view schematically showing a sticking process of the PZT piezoelectric-body film in step ST208 in Fig. 16, and Fig. 22B is a top view showing a state in which the PZT piezoelectric-body film has been stuck; and
Fig. 23A is a cross-sectional view showing a manufacturing process of the next piezoelectric-body film joint substrate, and Fig. 23B is a top view showing a state in which the PZT piezoelectric-body film has been stuck.

### DETAILED DESCRIPTION OF THE INVENTION

A piezoelectric-body film joint substrate and a manufacturing method thereof according to each embodiment will be described below with reference to the drawings. The following embodiments are just examples and a variety of modifications are possible within the scope of the present disclosure. In the present application, the piezoelectric-body film joint substrate is a product as an intermediate in which a plurality of piezoelectric films are provided on the same substrate. While the piezoelectric films are desired to be monocrystalline piezoelectric films, it is also possible to form the piezoelectric-body film joint substrate with polycrystalline piezoelectric films.

By using a piezoelectric-body film joint substrate according to each embodiment, a piezoelectric film integrated device including a plurality of piezoelectric bodies can be manufactured. The piezoelectric film integrated device is an acoustic oscillation sensor, for example. Incidentally, the acoustic oscillation sensor is a sensor that detects status (e.g., distance, shape, movement or the like) of a detection target object by outputting an acoustic oscillatory wave and detecting reflected waves of the acoustic oscillatory wave. The acoustic oscillation sensor is referred to also as an "ultrasonic sensor". In general, and in the present application, the acoustic oscillatory wave is made up of at least one of a sonic wave and an ultrasonic wave. Namely, the acoustic oscillatory wave includes a sonic wave, an ultrasonic wave, or both of a sonic wave and an ultrasonic wave.

### (1-1) Structure of Piezoelectric-Body Film Joint Substrate 100

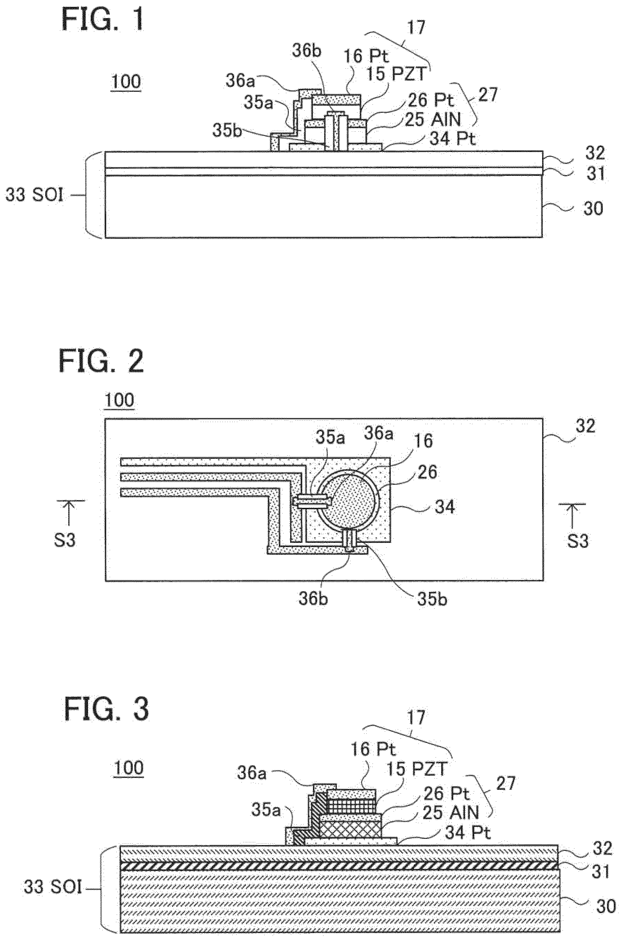

Fig. 1 is a side view schematically showing the structure of a piezoelectric-body film joint substrate 100 not forming part of the invention.

Fig. 2 is a top view schematically showing the structure of the piezoelectric-body film joint substrate 100. Fig. 3 is a cross-sectional view of the piezoelectric-body film joint substrate 100 in Fig. 2 taken along the line S3-S3.

The piezoelectric-body film joint substrate 100 includes an SOI substrate 33 as a substrate and a platinum (Pt) film 34 as an electrode (i.e., substrate electrode) provided on the SOI substrate 33. As shown in Fig. 2, the Pt film 34 is connected to a wiring layer formed on the SOI substrate 33. The SOI stands for Silicon On Insulator. Further, in the SOI substrate 33, there may be formed a drive circuit for driving the piezoelectric-body film joint substrate 100 and thereby generating the acoustic oscillatory wave, a processing circuit that executes a process by using an acoustic oscillatory wave detection signal, and so forth.

The piezoelectric-body film joint substrate 100 includes an AlN piezoelectric-body film 27 as a first piezoelectric-body film stuck (i.e., bonded) on the Pt film 34 being the substrate electrode and a PZT piezoelectric-body film 17 as a second piezoelectric-body film stuck (i.e., bonded) on the AlN piezoelectric-body film 27. The AlN piezoelectric-body film 27 includes an AlN film 25 as a first piezoelectric film and a Pt film 26 as a first upper electrode film formed on the AlN film 25. The PZT piezoelectric-body film 17 includes a PZT film 15 as a second piezoelectric film different from the first piezoelectric film (e.g., in crystal structure) and a Pt film 16 as a second upper electrode film formed on the PZT film 15, and is stuck on the Pt film 26. Further, area of the PZT piezoelectric-body film 17 and area of the AlN piezoelectric-body film 27 differ from each other. The area of the PZT piezoelectric-body film 17 is smaller than the area of the AlN piezoelectric-body film 27.

The AlN represents aluminum nitride. The PZT represents piezoelectric zirconate titanate (lead zirconate titanate). As the first piezoelectric-body film, instead of the AlN piezoelectric-body film, a different piezoelectric film such as a lithium tantalate (LiTaO₃) piezoelectric-body film or a lithium niobate (LiNbO₃) piezoelectric-body film may be used. As the second piezoelectric-body film, instead of the PZT piezoelectric-body film, a different piezoelectric-body film such as a potassium sodium niobate (KNN) piezoelectric-body film or a barium titanate (BaTiO₃) piezoelectric-body film may be used. Further, while the first and second piezoelectric-body films are desired to be monocrystalline piezoelectric-body films, polycrystalline piezoelectric-body films may also be used. In the illustrated example, the first piezoelectric-body film is a piezoelectric body that detects the acoustic oscillatory wave (or its reflected waves), and is a piezoelectric body having lower specific inductive capacity and higher detection sensitivity compared to the second piezoelectric-body film. The second piezoelectric-body film is a piezoelectric body that generates the acoustic oscillatory wave, and is desired to be a piezoelectric body having a higher piezoelectric constant and capable of obtaining greater oscillation amplitude compared to the first piezoelectric-body film.

Incidentally, it is permissible even if the first piezoelectric-body film as a piezoelectric-body film on a lower side includes a PZT film and a Pt film and the second piezoelectric-body film as a piezoelectric-body film on an upper side includes an AlN film and a Pt film overlaid on the AlN film.

Further, as shown in Fig. 1, the piezoelectric-body film joint substrate 100 includes an insulation film 35a, a wiring film 36a formed on the insulation film 35a, an insulation film 35b, and a wiring film 36b formed on the insulation film 35b.

The SOI substrate 33 includes a Si substrate 30, a silicon dioxide (SiO₂) part 31 as an insulation film, and a monocrystalline silicon (monocrystalline Si) part 32. A cavity (hole) may be formed by etching the Si substrate 30 in a region of the monocrystalline Si part 32 under the PZT film 15 and the AlN film 25 (i.e., region overlapping with the piezoelectric films). The SiO₂ part 31 and the monocrystalline Si part 32 situated in the region where the cavity is formed have a function as a vibrating plate. Further, as the substrate, a substrate made of a different material such as a glass substrate or an organic film substrate may also be used instead of the SOI substrate 33. The acoustic oscillatory wave generated by the PZT film 15 is outputted through the cavity, and the AlN film 25 detects reflected waves of the acoustic oscillatory wave through the cavity.

The thickness of the PZT film 15 is generally in a range of 10 nm to 10 µm, and preferably in a range of 100 nm to 5 µm. The thickness of the AlN film 25 is generally in a range of 10 nm to 10 µm, and preferably in a range of 100 nm to 2 µm. The Pt film 34 is formed on the upper surface of the SOI substrate 33. The surface (upper surface) of the Pt film 34 and the AlN piezoelectric-body film 27 are joined together by intermolecular force. The surface of the Pt film 26 of the AlN piezoelectric-body film 27 and the PZT piezoelectric-body film 17 are joined together by intermolecular force. For these joints, the use of an adhesive agent is unnecessary. For excellently joining these surfaces by intermolecular force, the surface roughness of a sticking surface of the AlN piezoelectric-body film 27, a sticking surface of the PZT piezoelectric-body film 17, the Pt film 34 and the Pt film 26 is desired to be less than or equal to 10 nm. For this purpose, processes for smoothing the surfaces of the Pt film 34 and the Pt film 26 may be executed. Further, an interface when the sticking surface of the AlN piezoelectric-body film 27 has been stuck on the Pt film 34 is less than or equal to 10 nm. Furthermore, area of the surface of the Pt film 34 is desired to be larger than area of the sticking surface of the AlN piezoelectric-body film 27. Thanks to such structure, a permissible range of a sticking accuracy error when the AlN piezoelectric-body film 27 is stuck on the Pt film 34 can be made wide.

### (1-2) Manufacturing Method

In the manufacture of the piezoelectric-body film joint substrate 100, the AlN piezoelectric-body film 27 formed on a growth substrate 21 and including the AlN film 25 and the Pt film 26 formed on the AlN film 25 and the PZT piezoelectric-body film 17 formed on a growth substrate 11 and including the PZT film 15 and the Pt film 16 formed on the PZT film 15 are peeled off respectively from the growth substrates 21 and 11, the AlN piezoelectric-body film 27 is stuck on the Pt films 34 as the electrode formed on the SOI substrate 33 different from both of the growth substrates 21 and 11, and the PZT piezoelectric-body film 17 is stuck on the AlN piezoelectric-body film 27.

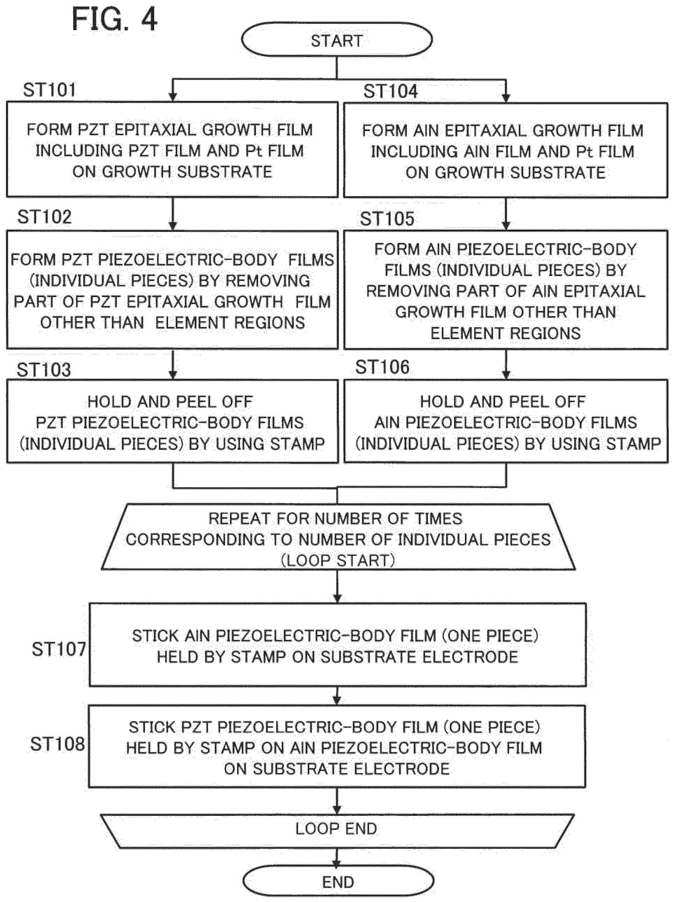

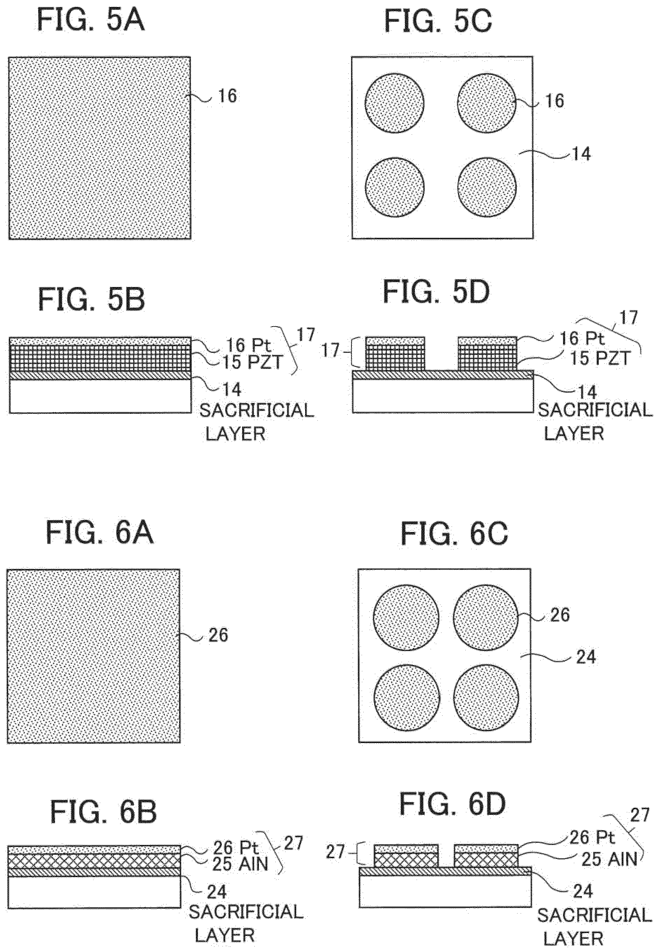

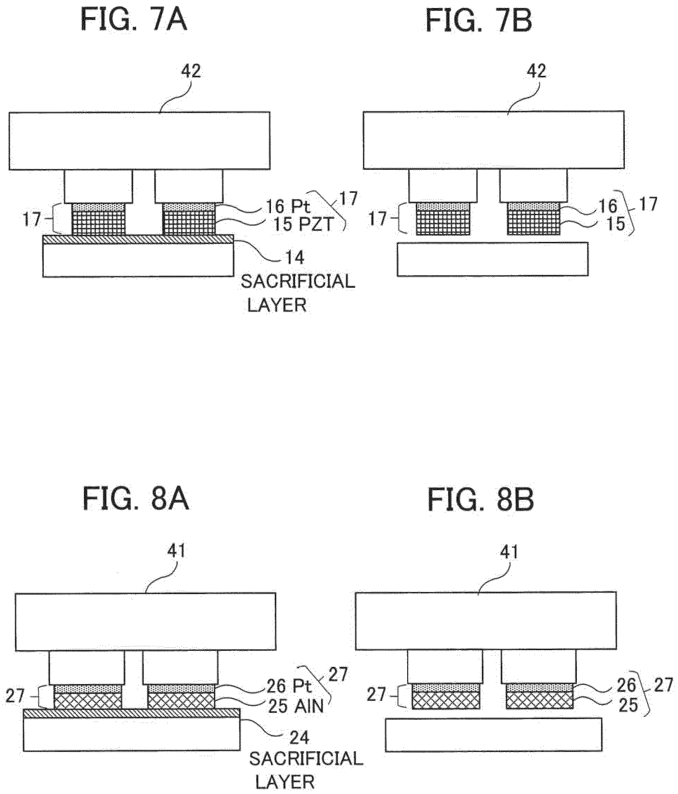

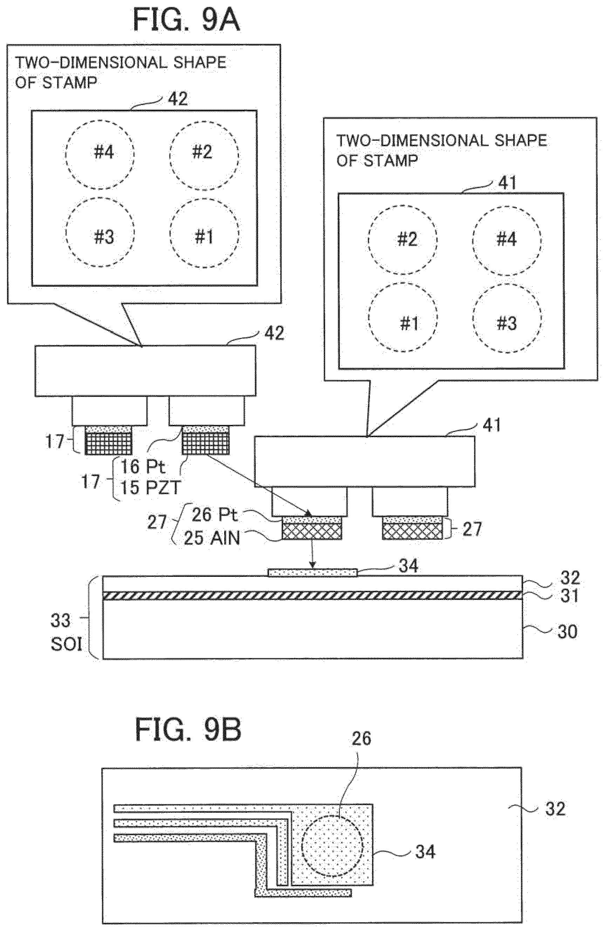

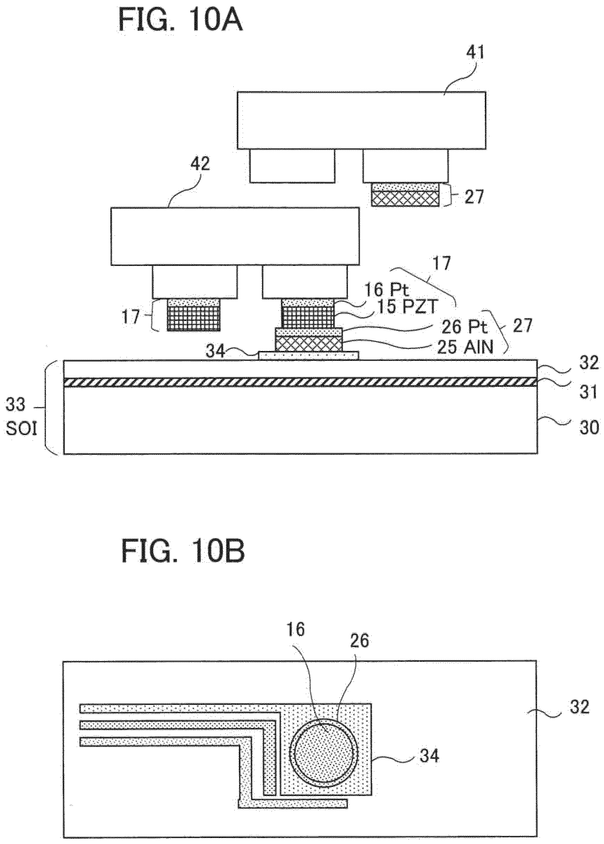

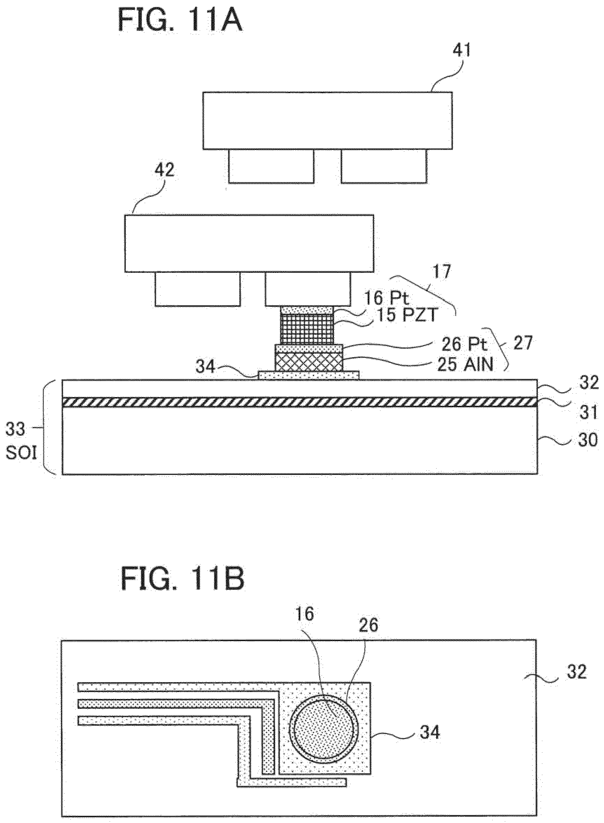

Fig. 4 is a flowchart showing a method of manufacturing the piezoelectric-body film joint substrate 100. Figs. 5A and 5B are a top view and a cross-sectional view schematically showing the structure of a PZT epitaxial growth film in step ST101 in Fig. 4. Figs. 5C and 5D are a top view and a cross-sectional view schematically showing the structure of the PZT epitaxial growth film in step ST102 in Fig. 4. Figs. 6A and 6B are a top view and a cross-sectional view schematically showing the structure of an AlN epitaxial growth film in step ST104 in Fig. 4. Figs. 6C and 6D are a top view and a cross-sectional view schematically showing the structure of the AlN epitaxial growth film in step ST105 in Fig. 4. Figs. 7A and 7B are cross-sectional views schematically showing a holding process of a plurality of PZT piezoelectric-body films 17 in step ST103 in Fig. 4. Figs. 8A and 8B are cross-sectional views schematically showing a holding process of a plurality of AlN piezoelectric-body films 27 in step ST106 in Fig. 4. Fig. 9A is a cross-sectional view schematically showing a sticking process of the AlN piezoelectric-body film 27 in step ST107 in Fig. 4, and Fig. 9B is a top view showing a state in which the AlN piezoelectric-body film 27 has been stuck. Fig. 10A is a cross-sectional view schematically showing a sticking process of the PZT piezoelectric-body film 17 in step ST108 in Fig. 4, and Fig. 10B is a top view showing a state in which the PZT piezoelectric-body film 17 has been stuck. Fig. 11A is a cross-sectional view showing a manufacturing process of the next piezoelectric-body film joint substrate, and Fig. 11B is a top view showing a state in which the PZT piezoelectric-body film 17 has been stuck.

First, a sacrificial layer 14, the PZT film 15 and the Pt film 16 are grown epitaxially on a growth substrate as shown in Figs. 5A and 5B (step ST101), and a plurality of PZT piezoelectric-body films 17 are formed by forming the PZT film 15 and the Pt film 16 into circular shapes by means of etching as shown in Figs. 5C and 5D (step ST102).

Further, a sacrificial layer 24, the AlN film 25 and the Pt film 26 are grown epitaxially on another growth substrate as shown in Figs. 6A and 6B (step ST104), and a plurality of AlN piezoelectric-body films 27 are formed by forming the AlN film 25 and the Pt film 26 into circular shapes by means of etching as shown in Figs. 6C and 6D (step ST105) .

Subsequently, as shown in Figs. 7A and 7B, the plurality of (4 in the illustrated example) PZT piezoelectric-body films 17 as individual pieces each formed with the PZT film 15 and the Pt film 16 are held by a stamp 42 as a holding member and are peeled off by etching the sacrificial layer (step ST103). Further, as shown in Figs. 8A and 8B, the plurality of (4 in the illustrated example) AlN piezoelectric-body films 27 as individual pieces each formed with the AlN film 25 and the Pt film 26 are held by a stamp 41 as a holding member and are peeled off by etching the sacrificial layer (step ST106).

Subsequently, as shown in Figs. 9A and 9B, one of the plurality of AlN piezoelectric-body films 27 held by the stamp 41 is stuck on the Pt film 34 (step ST107).

Subsequently, as shown in Figs. 10A and 10B, one of the plurality of PZT piezoelectric-body films 17 held by the stamp 42 is stuck on the Pt film 26 of the AlN piezoelectric-body film 27 that has been stuck on the Pt film 34 (step ST108). It is also possible to add a process of strengthening the sticking of Pt and each piezoelectric film by performing an annealing process after the sticking.

As shown in Figs. 9A and 9B, contact electrodes and a wiring pattern are formed with Pt on the SOI substrate 33, the AlN piezoelectric-body film 27 is stuck, and thereafter the PZT piezoelectric-body film 17 is overlaid and stuck on the Pt film 26 as the upper electrode film of the AlN piezoelectric-body film 27. In cases where the AlN piezoelectric-body films 27 held by the stamp 41 are in a 2 x 2 matrix, the AlN piezoelectric-body films 27 are successively stuck on different SOI substrates 33 in the illustrated order of #1, #2, #3 and #4. In this case, the AlN piezoelectric-body film 27 as the piezoelectric-body film having greater diameter is stuck first. In this example, four SOI substrates 33 are prepared for the four piezoelectric-body films. The PZT piezoelectric-body film 17 is stuck on the AlN piezoelectric-body film 27 as shown in Figs. 10A and 10B. The sticking is executed successively in the order of #1, #2, #3 and #4, and thus the stamp 42 as the holding member for sticking the PZT piezoelectric-body film 17 on the AlN piezoelectric-body film 27 is capable of executing the sticking without interfering with the AlN piezoelectric-body film 27 as shown in Fig. 11A.

Subsequently, the insulation film 35a and the wiring film 36a are formed on the PZT film 15 and the Pt film 16, and the insulation film 35b and the wiring film 36b are formed on the AlN film 25 and the Pt film 26.

At the time of the sticking, the hexagonal crystal of AlN and the cubic crystal of PZT are arranged in a phase relationship so that their c-axes are parallel to each other, by which efficiency of the piezoelectric oscillation driving of the PZT film 15 and the piezoelectric oscillation reception of the AlN film 25 is maximized.

### (1-3) Modification

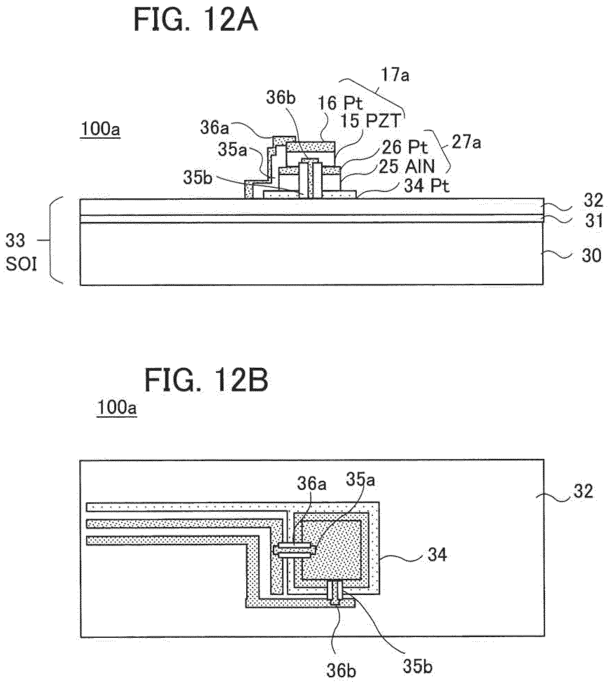

Figs. 12A and 12B are a side view and a top view schematically showing the structure of a piezoelectric-body film joint substrate 100a not forming part of the invention.

The piezoelectric-body film joint substrate 100a differs from the piezoelectric-body film joint substrate 100 shown in Fig. 1 to Fig. 3 in that the two-dimensional shape of each of an AlN piezoelectric-body film 27a and a PZT piezoelectric-body film 17a is a quadrangular shape. Except for this feature, the piezoelectric-body film joint substrate 100a is the same as the piezoelectric-body film joint substrate 100.

### (1-4) Effect

As described above, the PZT piezoelectric-body film 17 and the AlN piezoelectric-body film 27, which are unlikely to grow epitaxially on the same SOI substrate 33 because of the difference in the lattice constant and the crystal structure, are respectively formed on separate growth substrates, peeled off from the growth substrates, and stuck on a common SOI substrate 33 in superimposition with each other, by which a high-performance piezoelectric-body film joint substrate 100 can be made.

Further, since the PZT film 15 being monocrystalline has a higher piezoelectric constant compared to a polycrystalline PZT film, amplitude of the oscillation can be increased with ease. Furthermore, since the AlN film 25 being monocrystalline has lower specific inductive capacity compared to a polycrystalline AlN film, the oscillation reception sensitivity can be increased. However, the PZT film 15 may contain polycrystalline PZT, and the AlN film 25 may contain polycrystalline AlN. Namely, monocrystallization ratios of the PZT film 15 and the AlN film 25 may be less than or equal to 100%.

Furthermore, conventionally, in order to form piezoelectric films of different types, a process like temporarily covering one piezoelectric film with a protective layer, forming the other piezoelectric film, and thereafter removing the protective layer used to be a complicated process, and application of heat in processing in each step used to leave residual stress distortion in the piezoelectric films and cause deterioration in the efficiency of the sensor. By the manufacturing method described above, the piezoelectric-body film joint substrate and the acoustic oscillation sensor can be formed in a state with no residual stress distortion.

### (2-1) Structure of piezoelectric-body film Joint Substrate 200

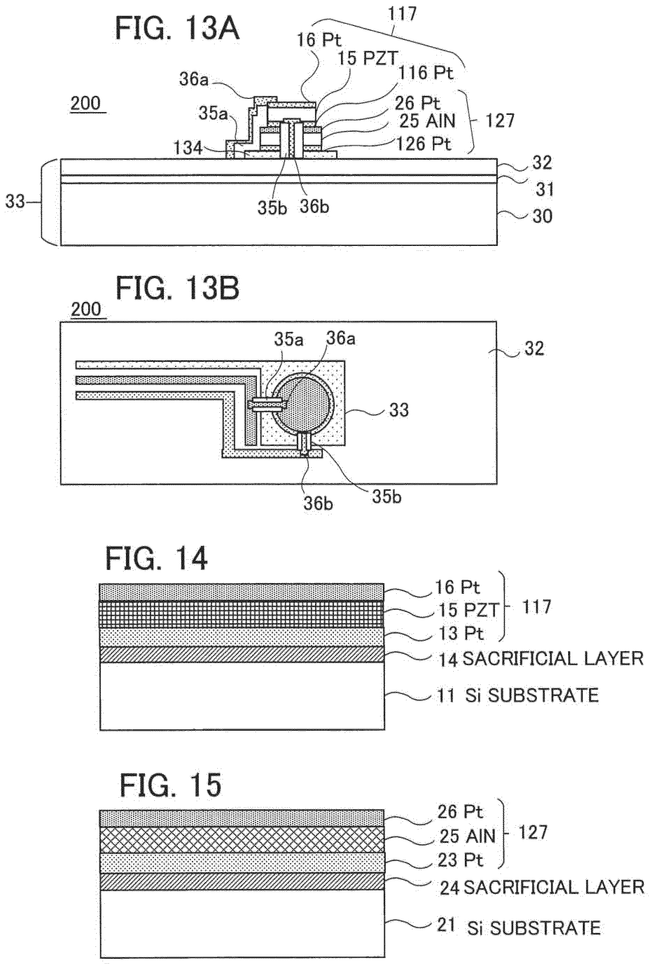

Figs. 13A and 13B are a side view and a top view schematically showing the structure of a piezoelectric-body film joint substrate 200 according to the invention. In Figs. 13A and 13B, each component identical or corresponding to a component shown in Fig. 1 to Fig. 3 is assigned the same reference character as in Fig. 1 to Fig. 3.

The piezoelectric-body film joint substrate 200 includes an AlN piezoelectric-body film 127 as a first piezoelectric-body film stuck on a Pt film 134 and a PZT piezoelectric-body film 117 as a second piezoelectric-body film stuck on the AlN piezoelectric-body film 127. The AlN piezoelectric-body film 127 includes a Pt film 126 as a first lower electrode film, the AlN film 25 as a first piezoelectric film formed on the Pt film 126, and the Pt film 26 as a first upper electrode film formed on the AlN film 25. The PZT piezoelectric-body film 117 includes a Pt film 116 as a second lower electrode film, the PZT film 15 as a second piezoelectric film different from the first piezoelectric film (e.g., in crystal structure), and the Pt film 16 as a second upper electrode film formed on the PZT film 15, and the Pt film 116 is stuck on the Pt film 26. Further, area of the PZT piezoelectric-body film 117 and area of the AlN piezoelectric-body film 127 differ from each other. In this embodiment, the area of the PZT piezoelectric-body film 117 is smaller than the area of the AlN piezoelectric-body film 127. Except for the above-described features, the structure of the piezoelectric-body film joint substrate 200 is the same as that of the piezoelectric-body film joint substrate 100. While the substrate electrode is formed with Pt (platinum) in this example, it is not particularly necessary to limit the material of the substrate electrode to Pt. For example, the substrate electrode may be formed with a variety of metal such as gold, aluminum or copper.

### (2-2) Manufacturing Method

Fig. 14 is a cross-sectional view schematically showing the structure of an epitaxial growth film including the PZT piezoelectric-body film 117. Fig. 15 is a cross-sectional view schematically showing the structure of an epitaxial growth film including the AlN piezoelectric-body film 127. In the manufacture of the piezoelectric-body film joint substrate 200, the AlN piezoelectric-body film 127 as the first piezoelectric-body film formed on the growth substrate 21 and including the Pt film 126, the AlN film 25 and the Pt film 26 and the PZT piezoelectric-body film 117 formed on the growth substrate 11 and including the Pt film 116, the PZT film 15 and the Pt film 16 are peeled off respectively from the growth substrates 21 and 11, the AlN piezoelectric-body film 127 is stuck on the Pt films 134 formed on the SOI substrate 33 different from both of the growth substrates 21 and 11, and the PZT piezoelectric-body film 117 is stuck on the AlN piezoelectric-body film 127.

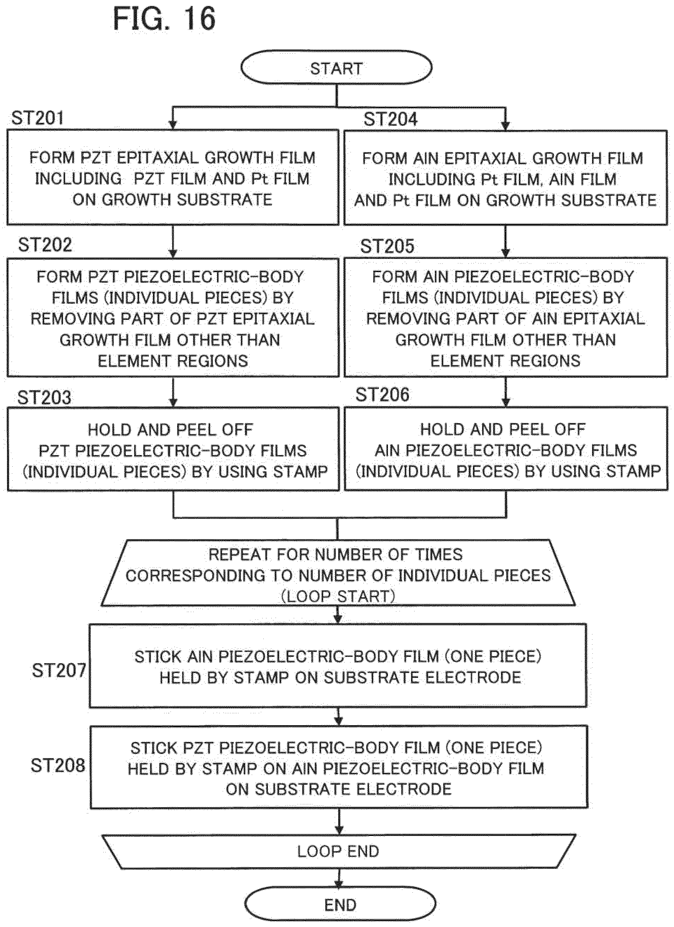

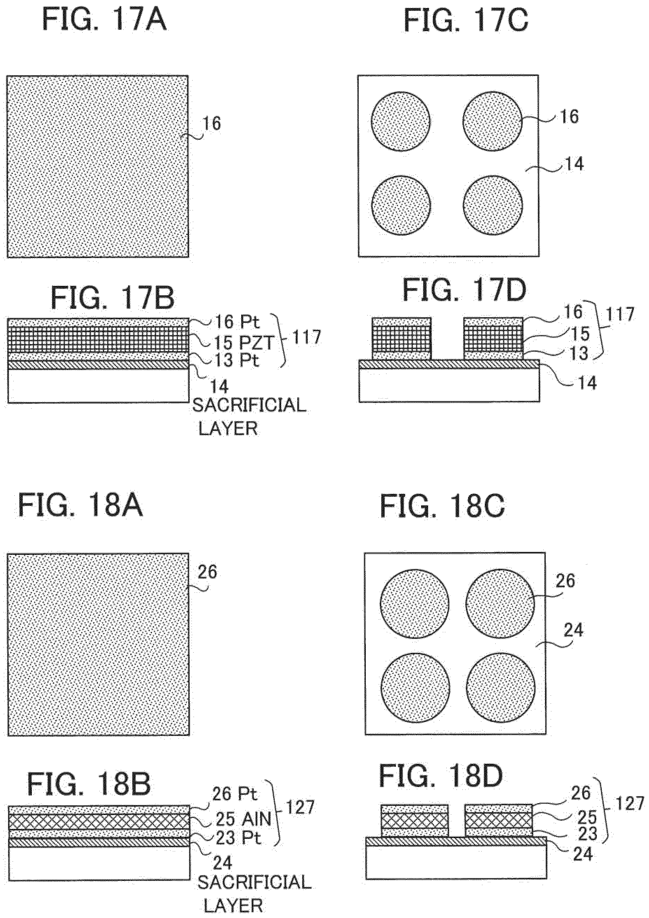

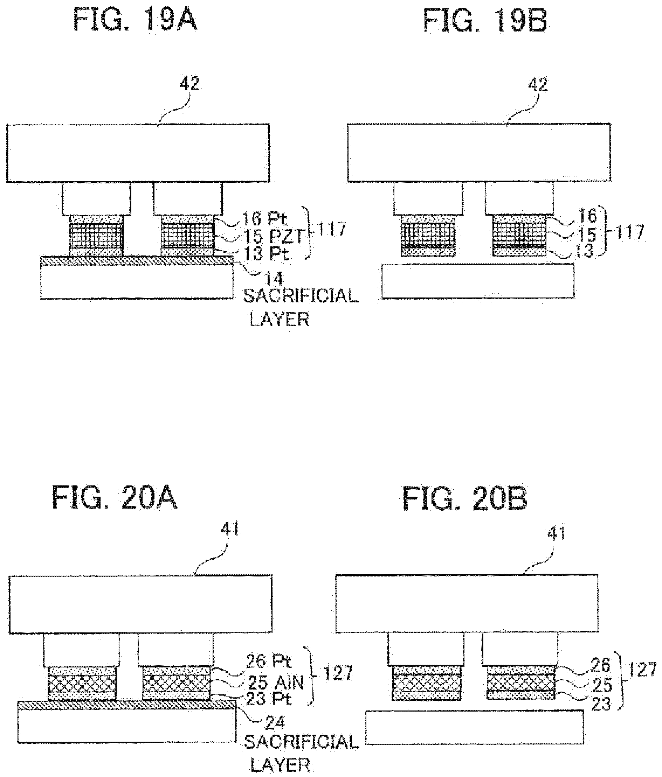

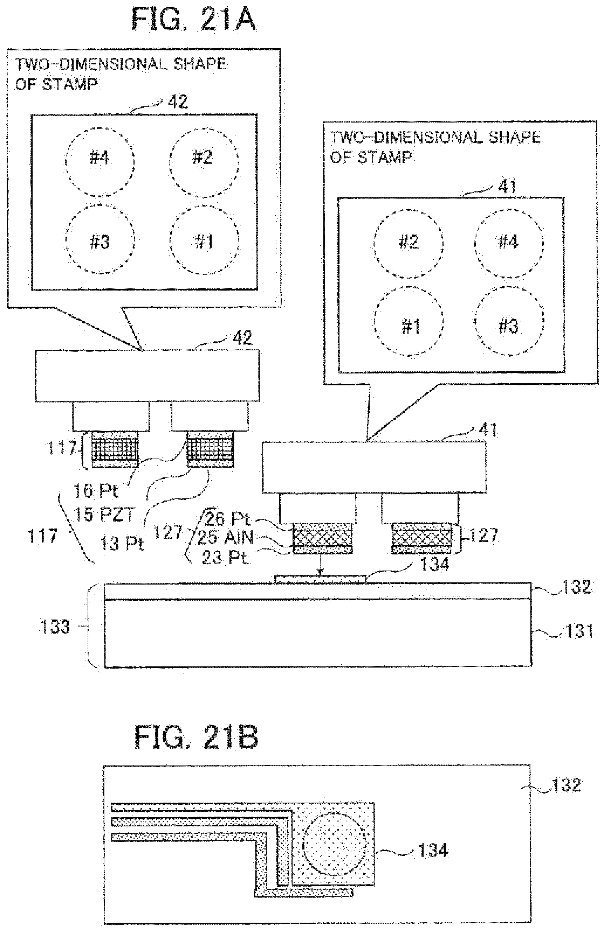

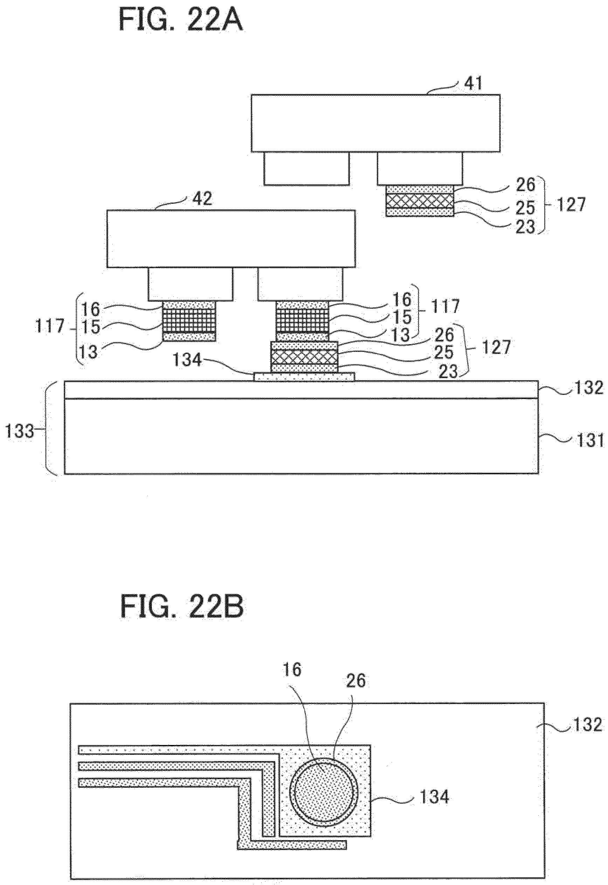

Fig. 16 is a flowchart showing a method of manufacturing the piezoelectric-body film joint substrate 200. Figs. 17A and 17B are a top view and a cross-sectional view schematically showing the structure of a PZT epitaxial growth film in step ST201 in Fig. 16. Figs. 17C and 17D are a top view and a cross-sectional view schematically showing the structure of the PZT epitaxial growth film in step ST202 in Fig. 16. Figs. 18A and 18B are a top view and a cross-sectional view schematically showing the structure of an AlN epitaxial growth film in step ST204 in Fig. 16. Figs. 18C and 18D are a top view and a cross-sectional view schematically showing the structure of the AlN epitaxial growth film in step ST205 in Fig. 16. Figs. 19A and 19B are cross-sectional views schematically showing a holding process of a plurality of PZT piezoelectric-body films 117 in step ST203 in Fig. 16. Figs. 20A and 20B are cross-sectional views schematically showing a holding process of a plurality of AlN piezoelectric-body films 127 in step ST206 in Fig. 16. Fig. 21A is a cross-sectional view schematically showing a sticking process of the AlN piezoelectric-body film 127 in step ST207 in Fig. 16, and Fig. 21B is a top view showing a state in which the AlN piezoelectric-body film 127 has been stuck. Fig. 22A is a cross-sectional view schematically showing a sticking process of the PZT piezoelectric-body film 117 in step ST208 in Fig. 16, and Fig. 22B is a top view showing a state in which the PZT piezoelectric-body film 117 has been stuck.

First, the sacrificial layer 14, a Pt film 13, the PZT film 15 and the Pt film 16 are grown epitaxially on a growth substrate as shown in Figs. 17A and 17B (step ST201), and a plurality of PZT piezoelectric-body films 117 are formed by forming the Pt film 13, the PZT film 15 and the Pt film 16 into circular shapes by means of etching as shown in Figs. 17C and 17D (step ST202).

Further, the sacrificial layer 24, a Pt film 23, the AlN film 25 and the Pt film 26 are grown epitaxially on another growth substrate as shown in Figs. 18A and 18B (step ST204), and a plurality of AlN piezoelectric-body films 127 are formed by forming the Pt film 23, the AlN film 25 and the Pt film 26 into circular shapes by means of etching as shown in Figs. 18C and 18D (step ST205).

Subsequently, as shown in Figs. 19A and 19B, the plurality of (4 in the illustrated example) PZT piezoelectric-body films 117 as individual pieces each formed with the Pt film 13, the PZT film 15 and the Pt film 16 are held by the stamp 42 as the holding member and are peeled off by etching the sacrificial layer (step ST203). Further, as shown in Figs. 20A and 20B, the plurality of (4 in the illustrated example) AlN piezoelectric-body films 127 as individual pieces each formed with the Pt film 23, the AlN film 25 and the Pt film 26 are held by the stamp 41 as the holding member and are peeled off by etching the sacrificial layer (step ST206).

Subsequently, as shown in Figs. 21A and 21B, one of the plurality of AlN piezoelectric-body films 127 held by the stamp 41 is stuck on the Pt film 134 (step ST207). In this embodiment, an example in which the Pt film 134 is formed on a glass polyimide multilayer substrate 133 is shown. The glass polyimide multilayer substrate 133 is formed with a glass part 131 and a polyimide part 132 stacked on the glass part 131, and the Pt film 134 is formed on the polyimide part 132.

Subsequently, as shown in Figs. 22A and 22B, one of the plurality of PZT piezoelectric-body films 117 held by the stamp 42 is stuck on the Pt film 26 of the AlN piezoelectric-body film 127 that has been stuck on the Pt film 134 (step ST208). While it is desirable in the first embodiment to add the process of strengthening the sticking of Pt and each piezoelectric film by performing the annealing process after the sticking, it is unnecessary to perform the annealing process in this embodiment since each piezoelectric-body film has structure including the Pt film 16, 26 as the upper electrode and the Pt film 13, 23 as the lower electrode.

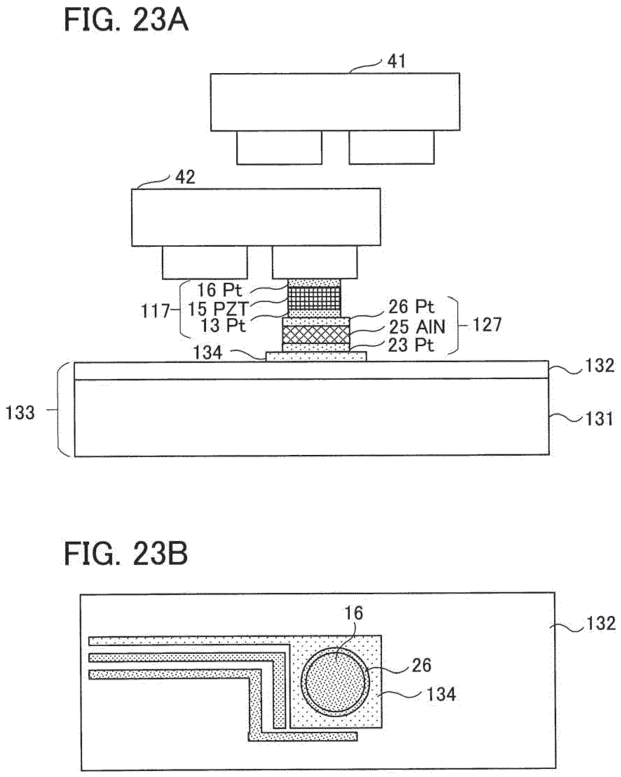

As shown in Figs. 23A and 23B, in this embodiment, the contact electrodes and the wiring pattern are formed with Pt on the glass polyimide multilayer substrate 133, the AlN piezoelectric-body film 127 is stuck, and thereafter the PZT piezoelectric-body film 117 is overlaid and stuck on the Pt film 26 as the upper electrode film of the AlN piezoelectric-body film 127. In cases where the AlN piezoelectric-body films 127 held by the stamp 41 are in a 2 x 2 matrix, the AlN piezoelectric-body films 27 are successively stuck on different glass polyimide multilayer substrates 133 in the illustrated order of #1, #2, #3 and #4. In this case, the AlN piezoelectric-body film 127 as the piezoelectric-body film having greater diameter is stuck first. In this example, four glass polyimide multilayer substrates 133 are prepared for the four piezoelectric-body films. The PZT piezoelectric-body film 117 is stuck on the AlN piezoelectric-body film 127 as shown in Figs. 22A and 22B. The sticking is executed successively in the order of #1, #2, #3 and #4, and thus the stamp 42 as the holding member for sticking the PZT piezoelectric-body film 117 on the AlN piezoelectric-body film 127 is capable of executing the sticking without interfering with the AlN piezoelectric-body film 127 as shown in Fig. 23A.

Subsequently, the insulation film 35a and the wiring film 36a are formed on the PZT film 15 and the Pt film 16, and the insulation film 35b and the wiring film 36b are formed on the AlN film 25 and the Pt film 26.

### (2-3) Effect

As described above, in this embodiment, the PZT piezoelectric-body film 117 and the AlN piezoelectric-body film 127, which are unlikely to grow epitaxially on the same glass polyimide multilayer substrate 133, are respectively grown epitaxially on separate growth substrates, peeled off from the growth substrates, and stuck on a common glass polyimide multilayer substrate 133 in superimposition with each other, by which a high-performance piezoelectric-body film joint substrate 200 can be made.

Further, according to the manufacturing method in this embodiment, the annealing process for stabilizing characteristics is necessary, and thus a plurality of piezoelectric-body films differing in the crystal structure can be provided on a non-heat-resistant substrate.

Incidentally, except for the above-described features, this embodiment is the same as the former not forming part of the invention.

### (3) Description of Reference Characters

100, 100a, 200: piezoelectric-body film joint substrate, 11, 21: growth substrate (monocrystalline Si substrate), 15: PZT film (second piezoelectric film), 16: Pt film (second upper electrode film), 13: Pt film (second lower electrode film), 14, 24: sacrificial layer, 17, 117: PZT piezoelectric-body film (second piezoelectric-body film), 23: Pt film (first lower electrode film), 25: AlN film (first piezoelectric film), 26: Pt film (first upper electrode film), 27, 127: AlN piezoelectric-body film (first piezoelectric-body film), 31: SiO₂ part, 32: monocrystalline Si part, 33: SOI substrate (substrate), 34, 134: Pt film (substrate electrode), 116: Pt film, 126: Pt film, 133: glass polyimide multilayer substrate.

## Claims

1. A piezoelectric-body film joint substrate (200) comprising:
a substrate (33, 133);
a substrate electrode (134) provided on the substrate (33, 133);
a first piezoelectric-body film (127) stuck on the substrate electrode (134) and including a first piezoelectric film (25) and a first upper electrode film (26) formed on the first piezoelectric film (25); and
a second piezoelectric-body film (117) stuck on the first upper electrode film (26) and including a second piezoelectric film (15) different from the first piezoelectric film (25) and a second upper electrode film (16) formed on the second piezoelectric film (15),
wherein the second piezoelectric-body film (117) further includes a second lower electrode film (13, 116) formed on a surface of the second piezoelectric film (15) on a side opposite to the second upper electrode film (16) and joined to the first upper electrode film (26), **characterized in that** the second lower electrode film (13, 116) has a first surface in contact with the second piezoelectric film (15) and a second surface on a side opposite to the first surface, a whole surface of the second surface being in direct contact with the first upper electrode film (26).

2. The piezoelectric-body film joint substrate (200) according to claim 1, wherein an area of the first piezoelectric-body film (127) and an area of the second piezoelectric-body film (117) differ from each other.

3. The piezoelectric-body film joint substrate (200) according to claim 1 or 2, wherein the area of the second piezoelectric-body film (117) is smaller than the area of the first piezoelectric-body film (127).

4. The piezoelectric-body film joint substrate (200) according to any one of claims 1 to 3, wherein the first piezoelectric-body film (127) further includes a first lower electrode film (23, 126) formed on a surface of the first piezoelectric film (25) on a side opposite to the first upper electrode film (26).

5. The piezoelectric-body film joint substrate (200) according to any one of claims 1 to 4, wherein the second piezoelectric film (15) is monocrystalline and the first piezoelectric film (25) is monocrystalline.

6. The piezoelectric-body film joint substrate (200) according to any one of claims 1 to 5, wherein an area of a surface of the substrate electrode (134) is larger than an area of a sticking surface of the first piezoelectric-body film (127) being stuck on the surface of the substrate electrode (134).

7. The piezoelectric-body film joint substrate (200) according to any one of claims 1 to 6, wherein
the first piezoelectric film (25) is an AlN film, a lithium tantalate film or a lithium niobate film, and
the second piezoelectric film (15) is a PZT film, a KNN film or a barium titanate film.

8. A method of manufacturing a piezoelectric-body film joint substrate (200), the method comprising:
peeling off a first piezoelectric-body film (27) formed on a first substrate (21) and including a first piezoelectric film (25) and a first electrode film (26) provided on the first piezoelectric film (25) and a second piezoelectric-body film (17) formed on a second substrate (11) and including a second piezoelectric film (15) and a second electrode film (16) provided on the second piezoelectric film (15) respectively from the first substrate (21) and the second substrate (11);
sticking the first piezoelectric-body film (27) on an electrode (134) formed on a third substrate (33,133) different from both of the first substrate (21) and the second substrate (11); and
sticking the second piezoelectric-body film (17) on the first piezoelectric-body film (27).

9. The method of manufacturing a piezoelectric-body film joint substrate (200) according to claim 8, wherein the second piezoelectric-body film (17) further includes a second lower electrode film (23) formed on a surface of the second piezoelectric film (15) on a side opposite to the second electrode film.

10. The method of manufacturing a piezoelectric-body film joint substrate (200) according to claim 8 or 9, wherein the first piezoelectric-body film (27) further includes a first lower electrode film (23) formed on a surface of the first piezoelectric film (25) on a side opposite to the first electrode film (26).

11. The method of manufacturing a piezoelectric-body film joint substrate (100, 200) according to any one of claims 8 to 10, wherein the second piezoelectric film (15) is monocrystalline and the first piezoelectric film (25) is monocrystalline.

12. The method of manufacturing a piezoelectric-body film joint substrate (100, 200) according to any one of claims 8 to 11, wherein an area of a surface of the electrode formed on the third substrate is larger than an area of a sticking surface of the first piezoelectric-body film (27) to be stuck on the surface of the electrode.

## Patentansprüche

1. Filmverbindungssubstrat mit piezoelektrischem Körper (200), umfassend:
ein Substrat (33, 133);
eine Substratelektrode (134), die auf dem Substrat (33, 133) bereitgestellt ist;
einen ersten piezoelektrischen Körperfilm (127), der auf der Substratelektrode aufgeklebt ist und einen ersten piezoelektrischen Film (25) und einen ersten oberen Elektrodenfilm (26) beinhaltet, der auf dem ersten piezoelektrischen Film (25) gebildet ist; und
einen zweiten piezoelektrischen Körperfilm (117), der auf dem ersten oberen Elektrodenfilm (26) aufgeklebt ist und einen zweiten piezoelektrischen Film (15), der sich von dem ersten piezoelektrischen Film (25) unterscheidet, und einen zweiten oberen Elektrodenfilm (16) beinhaltet, der auf dem zweiten piezoelektrischen Film (15) gebildet ist,
wobei der zweite piezoelektrische Körperfilm (117) ferner einen zweiten unteren Elektrodenfilm (13, 116) beinhaltet, der auf einer Oberfläche des zweiten piezoelektrischen Films (15) auf einer Seite gegenüber des zweiten oberen Elektrodenfilms (16) gebildet ist und mit dem ersten oberen Elektrodenfilm (26) verbunden ist, **dadurch gekennzeichnet, dass**
der zweite untere Elektrodenfilm (13, 116) eine erste Oberfläche, die in Kontakt mit dem zweiten piezoelektrischen Film (15) ist und eine zweite Oberfläche auf einer Seite gegenüber der ersten Oberfläche aufweist, wobei eine gesamte Oberfläche der zweiten Oberfläche in direktem Kontakt mit dem ersten oberen Elektrodenfilm (26) steht.

2. Filmverbindungssubstrat mit piezoelektrischem Körper (200) gemäß Anspruch 1, wobei ein Gebiet des ersten piezoelektrischen Körperfilms (127) und ein Gebiet des zweiten piezoelektrischen Körperfilms (117) sich voneinander unterscheiden.

3. Filmverbindungssubstrat mit piezoelektrischem Körper (200) gemäß Anspruch 1 oder 2, wobei das Gebiet des zweiten piezoelektrischen Körperfilms (117) kleiner als das Gebiet des ersten piezoelektrischen Körperfilms (127) ist.

4. Filmverbindungssubstrat mit piezoelektrischem Körper (200) gemäß einem der Ansprüche 1 bis 3, wobei der erste piezoelektrische Körperfilm (127) ferner einen ersten unteren Elektrodenfilm (23, 126) beinhaltet, der auf einer Oberfläche des ersten piezoelektrischen Films (25) auf einer Seite gegenüber des ersten oberen Elektrodenfilms (26) gebildet ist.

5. Filmverbindungssubstrat mit piezoelektrischem Körper (200) gemäß einem der Ansprüche 1 bis 4, wobei der zweite piezoelektrische Film (17) monokristallin ist und der erste piezoelektrische Film (25) monokristallin ist.

6. Filmverbindungssubstrat mit piezoelektrischem Körper (200) gemäß einem der Ansprüche 1 bis 5, wobei ein Gebiet einer Oberfläche der Substratelektrode (134) größer ist als ein Gebiet einer klebenden Oberfläche des ersten piezoelektrischen Körperfilms (127), die auf der Oberfläche der Substratelektrode (134) aufgeklebt ist.

7. Filmverbindungssubstrat mit piezoelektrischem Körper (200) gemäß einem der Ansprüche 1 bis 6, wobei
der erste piezoelektrische Film (25) ein AIN-Film, ein Lithiumtantalat-Film oder ein Lithiumniobat-Film ist, und
der zweite piezoelektrische Film (15) ein PZT-Film, ein KNN-Film oder ein Bariumtitanat-Film ist.

8. Verfahren zur Herstellung eines Filmverbindungssubstrat mit piezoelektrischem Körper (200), wobei das Verfahren umfasst:
Abziehen eines ersten piezoelektrischen Körperfilms (27), der auf einem ersten Substrat (21) gebildet ist und einen ersten piezoelektrischen Film (25) und einen ersten Elektrodenfilm beinhaltet (26), der auf dem ersten piezoelektrischen Film (25) bereitgestellt ist, und eines zweiten piezoelektrischen Körperfilms (17), der auf einem zweiten Substrat (11) gebildet ist und einen zweiten piezoelektrischen Film (15) und einen zweiten Elektrodenfilm (16) beinhaltet, der auf dem zweiten piezoelektrischen Film (15) bereitgestellt ist, jeweils von dem ersten Substrat (21) und dem zweiten Substrat (11);
Aufkleben des ersten piezoelektrischen Körperfilms (27) auf eine Elektrode (134), die auf einem dritten Substrat (33, 133) gebildet ist, das sich sowohl vom ersten Substrat (21) als auch vom zweiten Substrat (11) unterscheidet; und
Aufkleben des zweiten piezoelektrischen Körperfilms (17) auf den ersten piezoelektrischen Körperfilm (27).

9. Verfahren zur Herstellung eines Filmverbindungssubstrat mit piezoelektrischem Körper (200) gemäß Anspruch 8, wobei der zweite piezoelektrische Körperfilm (17) ferner einen zweiten unteren Elektrodenfilm (23) beinhaltet, der auf einer Oberfläche des zweiten piezoelektrischen Films (15) auf einer Seite gegenüber des zweiten Elektrodenfilms gebildet ist.

10. Verfahren zur Herstellung eines Filmverbindungssubstrat mit piezoelektrischem Körper (200) gemäß Anspruch 8 oder 9, wobei der erste piezoelektrische Körperfilm (27) ferner einen ersten unteren Elektrodenfilm (23) beinhaltet, der auf einer Oberfläche des ersten piezoelektrischen Films (25) auf einer Seite gegenüber des ersten Elektrodenfilms (26) gebildet ist.

11. Verfahren zur Herstellung eines Filmverbindungssubstrat mit piezoelektrischem Körper (100, 200) gemäß einem der Ansprüche 8 bis 10,
wobei der zweite piezoelektrische Film (15) monokristallin ist und der erste piezoelektrische Film (25) monokristallin ist.

12. Verfahren zur Herstellung eines Filmverbindungssubstrat mit piezoelektrischem Körper (100, 200) gemäß einem der Ansprüche 8 bis 11,
wobei ein Gebiet einer Oberfläche der Elektrode, die auf dem dritten Substrat gebildet ist, größer ist als ein Gebiet einer klebenden Oberfläche des ersten piezoelektrischen Körperfilms (27), der auf die Oberfläche der Elektrode geklebt werden soll.

## Revendications

1. Un substrat (200) de jonction de films à corps piézoélectrique comprenant ;
un substrat (33, 133) ;
une électrode de substrat (134), positionnée sur le substrat (33, 133) ;
un premier film (127) à corps piézoélectrique, fixé sur l'électrode de substrat (134) et comprenant un premier film piézoélectrique (25) et un premier film d'électrode supérieure (26) formé sur le premier film piézoélectrique (25) ; et
un deuxième film (117) à corps piézoélectrique, fixé sur le premier film d'électrode supérieure (26) et comprenant un deuxième film piézoélectrique (15) différent du premier film piézoélectrique (25) et un deuxième film d'électrode supérieure (16) formé sur le deuxième film piézoélectrique (15),
le deuxième film (117) à corps piézoélectrique comprenant en outre un deuxième film d'électrode inférieure (13, 116) formé sur une surface du
deuxième film piézoélectrique (15) sur un côté opposé au deuxième film d'électrode supérieure (16) et relié au premier film d'électrode supérieure (26), **caractérisé en ce que** le deuxième film d'électrode inférieure (13, 116) présente une première
surface en contact avec le deuxième film piézoélectrique (15) et une deuxième surface sur un côté opposé à la première surface, toute la surface de la deuxième surface étant en état de contact direct avec le premier film d'électrode supérieure (26).

2. Le substrat (200) de jonction de films à corps piézoélectrique selon la revendication 1, dans lequel une surface du premier film piézoélectrique (127) et une surface du deuxième film piézoélectrique (117) diffèrent l'une de l'autre.

3. Le substrat (200) de jonction de films à corps piézoélectrique selon la revendication 1 ou la revendication 2, dans lequel la surface du deuxième film (117) à corps piézoélectrique est plus petite que la surface du premier film (127) à corps piézoélectrique.

4. Le substrat (200) de jonction de films à corps piézoélectrique selon l'une quelconque des revendications 1 à 3, dans lequel le premier film (127) à corps piézoélectrique comprend en outre un premier film d'électrode inférieure (23, 126) formé sur une surface du premier film piézoélectrique (25) sur un côté opposé au premier film d'électrode supérieure (26).

5. Le substrat (200) de jonction de films à corps piézoélectrique selon l'une quelconque des revendications 1 à 4, dans lequel le deuxième film piézoélectrique (15) est monocristallin et le premier film piézoélectrique (25) est monocristallin.

6. Le substrat (200) de jonction de films à corps piézoélectrique selon l'une quelconque des revendications 1 à 5, dans lequel une surface de l'électrode de substrat (134) est plus grande qu'une surface de collage du premier film (127) à corps piézoélectrique fixée sur la surface de l'électrode de substrat (134).

7. Le substrat (200) de jonction de films à corps piézoélectrique selon l'une quelconque des revendications 1 à 6, dans lequel
le premier film piézoélectrique (25) est un film AlN, un film de tantalate de lithium ou un film de niobate de lithium, et
le deuxième film piézoélectrique (15) est un film PZT, un film KNN ou un film de titanate de baryum.

8. Un procédé de fabrication d'un substrat (200) de jonction de films à corps piézoélectrique, le procédé comprenant :
le fait de dépelliculer un premier film (27) à corps piézoélectrique formé sur un premier substrat (21) et incluant un premier film piézoélectrique (25) et un premier film d'électrode (26) positionné sur le premier film piézoélectrique (25) et un deuxième film (17) à corps piézoélectrique formé sur un deuxième substrat (11) et incluant un deuxième film piézoélectrique (15) et un deuxième film d'électrode (16) prévu sur le deuxième film piézoélectrique (15) respectivement à partir du premier substrat (21) et du deuxième substrat (11) ;
le fait de coller le premier film (27) à corps piézoélectrique sur une électrode (134) formée sur un troisième substrat (33, 133) différent à la fois du premier substrat (21) et du deuxième substrat (11) ; et
le fait de coller le deuxième film (17) à corps piézoélectrique sur le premier film (27) à corps piézoélectrique.

9. Le procédé de fabrication d'un substrat (200) de jonction de films à corps piézoélectrique selon la revendication 8, dans lequel le deuxième film (17) à corps piézoélectrique comprend en outre un deuxième film d'électrode inférieure (23) formé sur une surface du deuxième film piézoélectrique (15) sur un côté opposé au deuxième film d'électrode.

10. Le procédé de fabrication d'un substrat (200) de jonction de films à corps piézoélectrique selon la revendication 8 ou la revendication 9, dans lequel le premier film (27) à corps piézoélectrique comprend en outre un premier film d'électrode inférieure (23) formé sur une surface du premier film piézoélectrique (25) sur un côté opposé au premier film d'électrode (26).

11. Le procédé de fabrication d'un substrat de jonction de films à corps piézoélectrique (100, 200) selon l'une quelconque des revendications 8 à 10, dans lequel le deuxième film piézoélectrique (15) est monocristallin et le premier film piézoélectrique (25) est monocristallin.

12. Le procédé de fabrication d'un substrat de jonction de films à corps piézoélectrique (100, 200) selon l'une quelconque des revendications 8 à 11, dans lequel une surface de l'électrode formée sur le troisième substrat est plus grande que la surface de collage du premier film (27) à corps piézoélectrique destinée à être fixé sur la surface de l'électrode.
